# EUROPÄISCHE PATENTSCHRIFT

(11) **EP 0 989 674 B1**
(45) Veröffentlichungstag und Bekanntmachung des Hinweises auf die Patenterteilung: **22.12.2004**
(21) Anmeldenummer: 99118608.1
(22) Anmeldetag: 21.09.1999
(51) Int. Cl.: H03K 19/003

(54) **Integrierte Schaltung**
Integrated circuit
Circuit intégré

(30) Priorität: 21.09.1998 DE 19843159
(43) Veröffentlichungstag der Anmeldung: 29.03.2000
(73) Patentinhaber: Infineon Technologies AG, 81669 München (DE)
(72) Erfinder: Le, Thoai-Thai, 81737 München (DE)
(74) Vertreter: Epping, Hermann, Fischer

(56) Entgegenhaltungen:
- EP-A- 0 223 275
- WO-A-92/09140

## Beschreibung

Die Erfindung betrifft eine integrierte Schaltung, die eine erste Logikeinheit mit einem Aktivierungseingang aufweist und mit zwei Ausgängen, die über je eine Signalleitung mit je einem Eingang einer zweiten Logikeinheit verbunden sind, wobei die erste Logikeinheit im deaktivierten Zustand an beiden Ausgängen einen ersten Potentialpegel und im aktivierten Zustand an wenigstens einem der Ausgänge einen zweiten Potentialpegel ausgibt und wobei die zweite Logikeinheit wenigstens zwei Ausgänge aufweist, an denen sie in Abhängigkeit von Potentialwechseln an ihren Eingängen Potentialwechsel erzeugt.

Der Erfindung liegt die Aufgabe zugrunde, eine integrierte Schaltung der genannten Art anzugeben, bei der Pegelwechsel an mehreren der Ausgänge ihrer zweiten Logikeinheit, die durch Pegelwechsel an den Eingängen der zweiten Logikeinheit ausgelöst werden, gleichzeitig erfolgen, auch wenn die Signallaufzeiten auf den beiden Signalleitungen zwischen den Ausgängen der ersten Logikeinheit und den Eingängen der zweiten Logikeinheit voneinander abweichen.

Diese Aufgabe wird mit einer integrierten Schaltung gemäß Patentanspruch 1 gelöst. Eine vorteilhafte Weiterbildung der Erfindung ist Gegenstand eines abhängigen Anspruchs.

Die Erfindung wird im folgenden anhand der Figuren erläutert.

Es zeigen:
- Figur 1: ein Blockschaltbild eines Ausführungsbeispiels der integrierten Schaltung,
- Figur 2: ein detailliertes Schaltbild zum Ausführungsbeispiel aus Figur 1,
- Figur 3: beispielhafte Signalverzögerungen durch den in Figur 2 dargestellte Komponenten und
- Figur 4: Verläufe von in Figur 2 eingezeichneten Signalen.

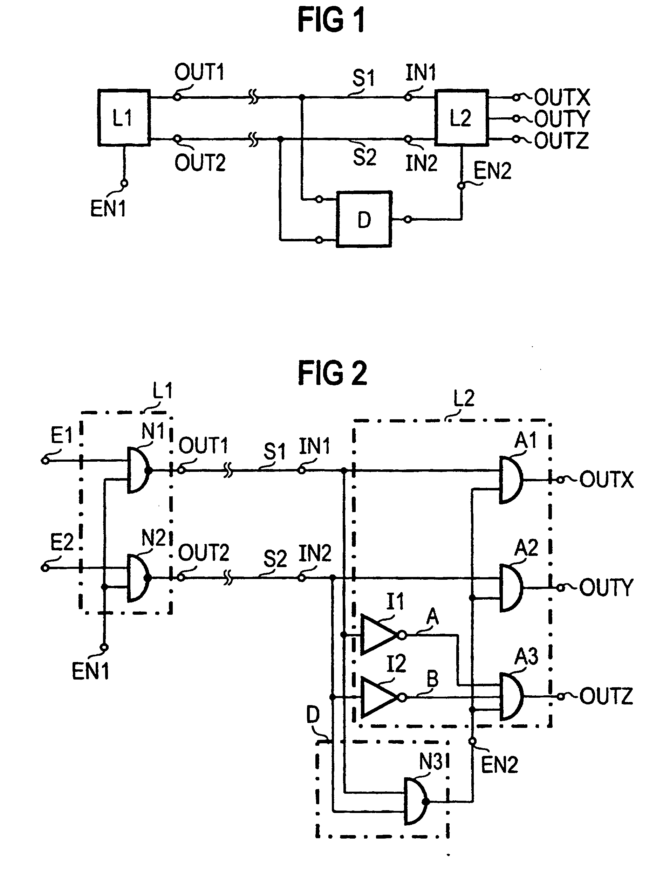

Figur 1 ist eine integrierte Schaltung zu entnehmen, die eine erste Logikeinheit mit einem Aktivierungseingang EN1 und zwei Ausgängen OUT1, OUT2 aufweist. Die integrierte Schaltung weist weiterhin eine zweite Logikeinheit L2 auf, die zwei Eingänge IN1, IN2, einen Aktivierungseingang EN2 sowie drei Ausgänge OUTX, OUTY, OUTZ aufweist. Die Ausgänge OUT1, OUT2 der ersten Logikeinheit L1 sind über je eine Signalleitung S1, S2 mit je einem der Eingänge IN1, IN2 der zweiten Logikeinheit L2 verbunden. Weiterhin weist die integrierte Schaltung eine Verzögerungseinheit D auf, mit zwei Eingängen, die mit je einer der Signalleitungen S1, S2 verbunden sind, und mit einem Ausgang, der mit dem Aktivierungseingang EN2 der zweiten Logikeinheit L2 verbunden ist.

Die Funktionsweise der in Figur 1 dargestellten Schaltung ist folgende:

Signale, die von der ersten Logikeinheit L1 zur zweiten Logikeinheit L2 übertragen werden, weisen in Abhängigkeit von der jeweiligen Signalleitung S1, S2 unterschiedliche Laufzeiten auf. Dies liegt beispielsweise an unterschiedlichen Längen der Signalleitungen S1, S2 oder einer sonstigen unterschiedlichen kapazitiven Last der beiden Signalleitungen. Wenn die erste Logikeinheit L1 über ihren Aktivierungseingang deaktiviert ist, gibt sie an ihren beiden Ausgängen OUT1, OUT2 jeweils einen ersten Potentialpegel aus, beim hier betrachteten Ausführungsbeispiel einen hohen Pegel. Wird die erste Logikeinheit L1 aktiviert, gibt sie an wenigstens einem ihrer Ausgänge OUT1, OUT2 einen zweiten Potentialpegel, in diesem Fall einen niedrigen Pegel, aus. Die Änderung der Signalpegel auf den beiden Signalleitungen S1, S2 bewirken an wenigstens einem der Ausgänge OUTX, OUTY, OUTZ der zweiten Logikeinheit L2 ebenfalls einen Pegelwechsel, jedoch nur, wenn die zweite Logikeinheit L2 über ihren Aktivierungseingang EN2 aktiviert ist. Ist die zweite Logikeinheit dagegen deaktiviert, wirken sich Pegeländerungen an ihren Eingängen IN1, IN2 nicht auf ihre Ausgangssignale aus.

Die Verzögerungseinheit D sorgt dafür, daß nach der Aktivierung der ersten Logikeinheit sich an mehr als einem Ausgang der zweiten Logikeinheit L2 ergebende Pegelwechsel gleichzeitig erfolgen, so daß der zweiten Logikeinheit L2 ausgangsseitig nachgeschaltete, in Figur 1 nicht dargestellte Schaltungseinheiten der integrierten Schaltung gleichzeitig diese Pegelwechsel übermittelt bekommen. Zu diesem Zweck deaktiviert die Verzögerungseinheit D die zweite Logikeinheit L2 über ihren Ausgang, sofern an ihren beiden Eingängen der erste Potentialpegel anliegt. Die Verzögerungseinheit D aktiviert die zweite Logikeinheit L2, sofern an wenigstens einem der Eingänge der Verzögerungseinheit der zweite Potentialpegel anliegt. Dabei löst die Verzögerungseinheit D aufgrund eines Pegelwechsels an einem ihrer Eingänge vom hohen auf den niedrigen Pegel an ihrem Ausgang einen zeitlich verzögerten Pegelwechsel aus, wobei die Verzögerung durch die Verzögerungseinheit wenigstens so lang ist, wie die Differenz der Signallaufzeiten auf den beiden Signalleitungen S1, S2.

Figur 2 zeigt ein detailliertes Schaltbild der integrierten Schaltung aus Figur 1. Anhand Figur 2 soll die Funktion der Schaltung näher erläutert werden. Die erste Logikeinheit L1 weist ein erstes NAND-Gatter N1 auf, dessen erster Eingang mit einem Eingangssignal E1 und dessen zweiter Eingang mit dem Aktivierungseingang EN1 der ersten Logikeinheit L1 verbunden ist. Außerdem weist sie ein zweites NAND-Gatter N2 auf, dessen erster Eingang mit einem zweiten Eingangssignal E2 und dessen zweiter Eingang ebenfalls mit dem Aktivierungseingang EN1 verbunden ist. Ein Ausgang des ersten NAND-Gatters N1 ist der erste Ausgang OUT1 und ein Ausgang des zweiten NAND-Gatters N2 ist der zweite Ausgang OUT2 der ersten Logikeinheit L1.

Die zweite Logikeinheit L2 weist ein erstes AND-Gatter A1 auf, dessen erster Eingang mit dem ersten Eingang IN1, dessen zweiter Eingang mit dem Aktivierungseingang EN2 und dessen Ausgang mit dem ersten Ausgang OUTX der zweiten Logikeinheit L2 verbunden ist. Weiterhin weist die zweite Logikeinheit L2 ein zweites AND-Gatter A2 auf, dessen erster Eingang mit dem zweiten Eingang IN2 und dessen zweiter Eingang mit dem Aktivierungseingang EN2 und dessen Ausgang mit dem zweiten Ausgang OUTY der zweiten Logikeinheit L2 verbunden ist. Die zweite Logikeinheit weist weiterhin einen ersten Inverter I1, auf, dessen Einang mit dem ersten Eingang IN1 der zweiten Logikeinheit L2 verbunden ist. Sie weist außerdem einen zweiten Inverter I2 auf, dessen Eingang mit dem zweiten Eingang IN2 der zweiten Logikeinheit L2 verbunden ist. Ferner weist sie ein drittes AND-Gatter A3 auf, dessen erster Eingang mit dem Ausgang A des ersten Inverters I1, dessen zweiter Eingang mit dem Ausgang B des zweiten Inverters I2 und dessen dritter Eingang mit dem Aktivierungseingang EN2 der zweiten Logikeinheit L2 verbunden ist. Ein Ausgang des dritten AND-Gatters A3 ist mit dem dritten Ausgang OUTZ der zweiten Logikeinheit L2 verbunden. Die Verzögerungseinheit D in Figur 2 weist ein drittes NAND-Gatter N3 auf, dessen Eingänge mit je einer der Signalleitung S1, S2 verbunden sind und dessen Ausgang mit dem Aktivierungseingang EN2 der zweiten Logikeinheit L2 verbunden ist.

Die erste Logikeinheit L1 ist deaktiviert, wenn an ihrem Aktivierungseingang EN1 ein niedriger Pegel anliegt. Dann ergibt sich an ihren beiden Ausgängen OUT1, OUT2 ein hoher Pegel. Liegt an den beiden Eingängen der Verzögerungseinheit D der hohe Pegel an, gibt sie an ihrem Ausgang einen niedrigen Pegel aus, wodurch die zweite Logikeinheit L2 deaktiviert wird. Da der niedrige Pegel am Aktivierungseingang EN2 allen drei AND-Gattern A1, A2, A3 zugeführt wird, gibt die zweite Logikeinheit L2 im deaktivierten Zustand jeweils einen niedrigen Pegel an ihren drei Ausgängen OUTX, OUTY, OUTZ aus. Die Verzögerungseinheit D sorgt also dafür, daß die zweite Logikeinheit L2 deaktiviert wird, wenn die erste Logikeinheit L1 deaktiviert ist. Die zweite Logikeinheit L2 weist dann ebenso wie die erste Logikeinheit L1, an ihren Ausgängen jeweils definierte Pegel auf, im vorliegenden Fall niedrige Pegel.

Sobald die erste Logikeinheit L1 über ihren Aktivierungseingang EN1 aktiviert wird, indem an ihm ein hoher Pegel erzeugt wird, stellt sich an den Ausgängen OUT1, OUT2 der ersten Logikeinheit L1 ein Pegel ein, der invers zum Pegel der Eingangssignale E1, E2 ist. Die sich ergebenden Pegelwechsel an den Ausgängen OUT1, OUT2 der ersten Logikeinheit L1 breiten sich über die Signalleitungen S1, S2 zu den Eingänge IN1, IN2 der zweiten Logikeinheit L2 aus. In den Figuren 1 und 2 wurden die Signalleitungen S1, S2 nur ausschnittsweise dargestellt, da sie in Wirklichkeit eine viel größere Länge aufweisen als die restlichen in den Figuren dargestellten Verbindungsleitungen. Aufgrund der unterschiedlichen Signallaufzeiten auf den beiden Signalleitungen S1, S2 machen sich Pegelwechsel an den Ausgängen OUT1, OUT2 der ersten Logikeinheit L1 zu unterschiedlichen Zeitpunkten an den Eingängen IN1, IN2 der zweiten Logikeinheit L2 bemerkbar. Ohne die Verzögerungseinheit D und die mit ihr durchgeführte, im folgenden beschriebene verzögerte Aktivierung der zweiten Logikeinheit L2, würden diese Pegeländerungen an mehreren der Ausgänge OUTX, OUTY, OUTZ der zweiten Logikeinheit L2 auslösen, die nicht zeitgleich erfolgen würden. Die Verzögerungseinheit D sorgt dafür, daß eine Deaktivierung der zweiten Logikeinheit L2 und damit eine Auswertung der an ihren Eingängen IN1, IN2 anliegenden Signale erst dann erfolgt, wenn sich der nach der Aktivierung der ersten Logikeinheit L1 neu einstellende Pegel auf derjenigen Signalleitung mit der längeren Signallaufzeit sicher am entsprechenden Eingang IN1, IN2 der zweiten Logikeinheit L2 eingestellt hat.

Bei diesem Ausführungsbeispiel weisen das erste NAND-Gatter N1 und das zweite NAND-Gatter N2, die drei AND-Gatter A1, A2 und A3 und der erste Inverter I1 und der zweite Inverter I2, jeweils übereinstimmende Schaltzeiten auf. Die Schaltzeit des dritten NAND-Gatters N3 und damit die Verzögerung durch die Verzögerungseinheit D ist so gewählt, daß sie größer ist als die Laufzeitdifferenz der beiden Signalleitungen S1 und S2 zuzüglich der Schaltzeit der Inverter I1, I2. Daher bewirkt die Verzögerungseinheit D eine Aktivierung der zweiten Logikeinheit L2 erst dann, wenn sich an sämtlichen Eingängen der AND-Gatter A1, A2, A3 nach der Aktivierung der ersten Logikeinheit L1 bereits die von dem Pegel der Eingangsignale E1, E2 abhängigen Pegel sicher eingestellt haben.

Die Eingänge der Verzögerungseinheit D in den Figuren 1 und 2 sind mit den Signalleitungen S1, S2 im Bereich der Eingänge IN1 und IN2 der zweiten Logikeinheit L2 verbunden. Daher muß die Verzögerung durch die Verzögerungseinheit D nicht die gesamte Laufzeit der langsameren der beiden Signalleitungen S1, S2 nachbilden, wie es der Fall wäre, wenn die Eingänge der Verzögerungseinheit D direkt mit den Ausgängen OUT1, OUT2 der ersten Logikeinheit L1 verbunden wären, sondern nur die Laufzeitdifferenz der beiden Signalleitungen zuzüglich der Schaltzeit der Inverter I1, I2.

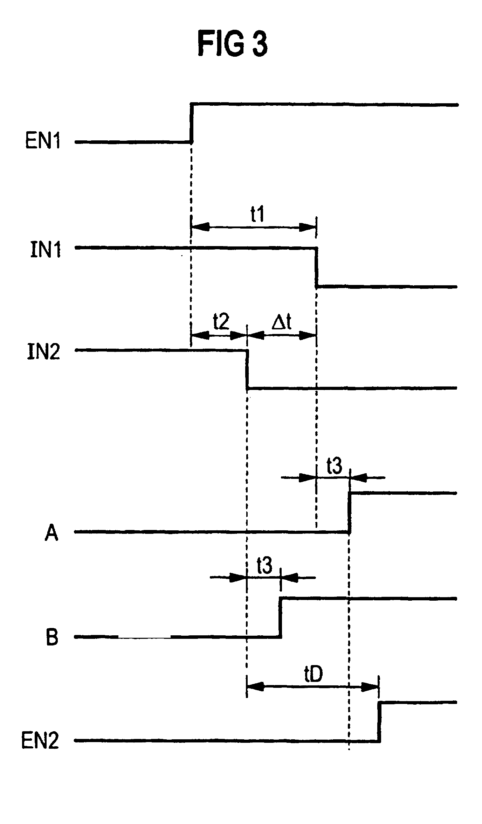

Figur 3 zeigt zur Verdeutlichung der unterschiedlichen Verzögerungszeiten innerhalb der Schaltung aus Figur 2 einige Signalverläufe. Dabei ist angenommen, daß beide Eingangssignale E1, E2 einen hohen Pegel aufweisen. Zunächst weist das Aktivierungsignal EN1 der ersten Logikeinheit L1 einen niedrigen Pegel auf. Die erste Logikeinheit L1 ist dadurch deaktiviert und ihre Ausgänge OUT1, OUT2 weisen (da sie unabhängig von den Eingangssignalen E1, E2 sind) einen hohen Pegel auf, der sich zeitlich verzögert auch an den Eingängen IN1, IN2 der zweiten Logikeinheit L2 einstellt. An den Ausgängen A, B der beiden Inverter I1, I2 stellt sich ein niedriger Pegel ein, ebenso wie am Aktivierungseingang EN2 der zweiten Logikeinheit L2. Eine positive Flanke des Aktivierungssignals EN1 der ersten Logikeinheit L1 bewirkt aufgrund der Signallaufzeiten auf den beiden Signalleitungen S1, S2 verzögerte Pegelwechsel an den Eingängen IN1, IN2 der zweiten Logikeinheit L2. Dabei weist die erste Signalleitung S1 eine längere Signallaufzeit t1 als die Signallaufzeit t2 der zweiten Signalleitung S2 auf. Die Differenz Δt der beiden Signallaufzeiten t1, t2 ist in Figur 3 ebenfalls eingezeichnet. Die Ausgangssignale A, B der beiden Inverter I1, I2 weisen erst nach einer Schaltzeit t3, die auf den jeweiligen Pegelwechsel am Eingang IN1, IN2 der zweiten Logikeinheit L2 folgt, ebenfalls einen Pegelwechsel auf. Die Verzögerungszeit tD der Verzögerungseinheit D ist größer als die Summe der Laufzeitdifferenz Δt und der Schaltzeit t3 der Inverter I1, I2. Nachdem am zweiten Eingang IN2 der zweiten Logikeinheit L2 die negative Flanke aufgetreten ist, bewirkt die Verzögerungseinheit D erst nach der Verzögerungszeit tD einen positiven Wechsel des zweiten Aktivierungssignals EN2, wodurch die zweite Logikeinheit L2 aktiviert wird. Die Verzögerungszeit tD der Verzögerungseinheit D entspricht der Schaltzeit ihres dritten NAND-Gatters N3.

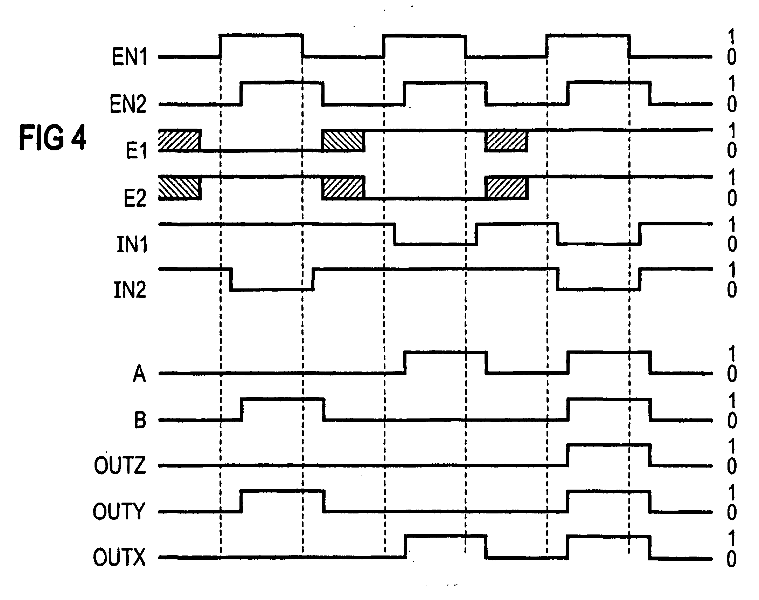

Figur 4 zeigt mehrere Aktivierungs- und Deaktivierungzyklen der Schaltung aus Figur 2 mit den entsprechenden Signalverläufen. Eine "Bewertung" der Pegel der Eingangssignale E1, E2 findet immer nur bei einem hohen Pegel des ersten Aktivierungssignals EN1 statt. Figur 4 zeigt drei aufeinander folgende aktive Zyklen, in denen das erste Aktivierungssignal EN1 jeweils einen hohen Pegel aufweist. Beim dritten Aktivierungszyklus in Figur 4 weisen beide Eingangsignale E1, E2 einen hohen Pegel auf. Figur 4 ist zu entnehmen, daß an den drei Ausgängen OUTX, OUTY, OUTZ der zweiten Logikeinheit L2 daraufhin gleichzeitig Pegelwechsel auftreten. Diese Gleichzeitigkeit von Pegelwechseln an mehreren der Ausgänge der zweiten Logikeinheit wird durch die Verzögerungseinheit D bewirkt.

## Patentansprüche

1. Integrierte Schaltung
- mit einer ersten Logikeinheit (L1) mit einem Aktivierungseingang (EN1) und mit zwei Ausgängen (OUT1, OUT2), die über je eine Signalleitung (S1, S2) mit je einem Eingang (IN1, IN2) einer zweiten Logikeinheit (L2) verbunden sind,
- deren erste Logikeinheit (L1) im deaktivierten Zustand an beiden Ausgängen (OUT1, OUT2) einen ersten Potentialpegel (1) ausgibt und im aktivierten Zustand an wenigstens einem der Ausgänge (OUT1, OUT2) einen zweiten Potentialpegel (O),
- mit einer Verzögerungseinheit (D) mit zwei Eingängen, die mit je einer der Signalleitungen (S1, S2) verbunden sind, und mit einem Ausgang, der mit einem Aktivierungseingang (EN2) der zweiten Logikeinheit (L2) verbunden ist,
- deren zweite Logikeinheit (L2) wenigstens zwei Ausgänge (OUTX, OUTY, OUTZ) aufweist, an denen sie aufgrund eines Pegelwechsels an einem ihrer Eingänge (IN1, IN2) nur dann einen Pegelwechsel erzeugt, wenn sie aktiviert ist,
- deren Verzögerungseinheit die zweite Logikeinheit (L2) über ihren Ausgang deaktiviert, sofern an ihren beiden Eingängen der erste Potentialpegel (1) anliegt, und die die zweite Logikeinheit (L2) aktiviert, sofern an einem ihrer Eingänge der zweite Potentialpegel (O) anliegt,
- und deren Verzögerungseinheit (D) aufgrund eines Pegelwechsels an einem ihrer Eingänge an ihrem Ausgang einen zeitlich verzögerten Pegelwechsel auslöst, wobei die Verzögerung durch die Verzögerungseinheit (D) wenigstens so lang ist wie die Differenz der Signallaufzeiten auf den beiden Signalleitungen (S1, S2) zwischen den Ausgängen (OUT1, OUT2) der ersten Logikeinheit und den Eingängen (IN1, IN2) der zweiten Logikeinheit (L2).

2. Integrierte Schaltung nach Anspruch 1,
bei der jeder Eingang der Verzögerungseinheit (D) an einer Stelle mit der jeweiligen Signalleitung (S1, S2) verbunden ist, die wesentlich näher an den Eingängen (IN1, IN2) der zweiten Logikeinheit (L2) als an den Ausgängen (OUT1, OUT2) der ersten Logikeinheit (L1) angeordnet ist.

## Claims

1. Integrated circuit
- having a first logic unit (L1) having an activation input (EN1) and having two outputs (OUT1, OUT2), which are connected to a respective input (IN1, IN2) of a second logic unit (L2) via a respective signal line (S1, S2),
- the first logic unit (L1) of which integrated circuit outputs a first potential level (1) at both outputs (OUT1, OUT2) in the deactivated state and a second potential level (0) at at least one of the outputs (OUT1, OUT2) in the activated state,
- having a delay unit (D) having two inputs, which are connected to a respective one of the signal lines (S1, S2), and having an output connected to an activation input (EN2) of the second logic unit (L2),
- the second logic unit (L2) of which integrated circuit has at least two outputs (OUTX, OUTY, OUTZ), at which it generates a level change on account of a level change at one of its inputs (IN1, IN2) only when it is activated,
- the delay unit of which integrated circuit deactivates the second logic unit (L2) via its output, provided that the first potential level (1) is present at its two inputs, and activates the second logic unit (L2), provided that the second potential level (0) is present at one of its inputs,
- and the delay unit (D) of which integrated circuit triggers a temporally delayed level change at its output on account of a level change at one of its inputs, the delay by the delay unit (D) being at least as long as the difference between the signal propagation times on the two signal lines (S1, S2) between the outputs (OUT1, OUT2) of the first logic unit and the inputs (IN1, IN2) of the second logic unit (L2).

2. Integrated circuit according to Claim 1,
in which each input of the delay unit (D) is connected to the respective signal line (S1, S2) at a point which is arranged significantly nearer to the inputs (IN1, IN2) of the second logic unit (L2) than to the outputs (OUT1, OUT2) of the first logic unit (L1).

## Revendications

1. Circuit intégré
- comprenant une première unité (L1) logique ayant une entrée (EN1) d'activation et ayant deux sorties (OUT1, OUT2) qui sont reliées par, respectivement, une ligne (S1, S2) de signal à, respectivement, une entrée (IN1, IN2) d'une deuxième unité (L2) logique ;
- dont la première unité (L1) logique émet à l'état désactivé sur les deux sorties (OUT1, OUT2) un premier niveau (1) de potentiel et à l'état activé sur au moins l'une des sorties (OUT1, OUT2) un deuxième niveau haut de potentiel ;
- comprenant une unité (D) de temporisation ayant deux entrées qui sont reliées à, respectivement, l'une des lignes (S1, S2) de signal et ayant une sortie qui est reliée à une entrée (EN2) d'activation de la deuxième unité (L2) logique ;
- dont la deuxième unité (L2) logique a au moins deux sorties (OUTX, OUTY, OUTZ) sur lesquelles elle produit, en raison d'un changement de niveau sur l'une de ses entrées (IN1, IN2), un changement de niveau seulement lorsqu'elle est activée ;
- dont l'unité de temporisation désactive la deuxième unité (L2) logique par sa sortie, pourvu que le premier niveau (1) de potentiel s'applique à ses deux entrées et active la deuxième unité (L2) logique, pourvu que le deuxième niveau haut de potentiel (0) s'applique à l'une de ses entrées ;
- et dont l'unité (D) de temporisation déclenche sur la base d'un changement de niveau sur l'une de ses entrées à sa sortie un changement de niveau retardé dans le temps, la temporisation par l'unité (D) de temporisation étant au moins aussi longue que la différence de temps de parcours du signal sur les deux lignes (S1, S2) de signal entre les sorties (OUT1, OUT2) de la première unité logique et les entrées (IN1, IN2) de la deuxième unité (L2) logique.

2. Circuit intégré suivant la revendication 1,
dans lequel chaque entrée de l'unité (D) de temporisation est reliée en un point à la ligne (S1, S2) respectif de signal qui est sensiblement plus proche des entrées (IN1, IN2) de la deuxième unité (L2) logique que des sorties (OUT1, OUT2) de la première unité (L1) logique.
